(19) **Europäisches Patentamt European Patent Office Office européen des brevets**

(11) **EP 4 576 970 A1**

(12) **EUROPEAN PATENT APPLICATION**

(43) Date of publication:
**25.06.2025 Bulletin 2025/26**

(21) Application number: **24221114.2**

(22) Date of filing: **18.12.2024**

(51) International Patent Classification (IPC):
**H05K 9/00** (2006.01)

(52) Cooperative Patent Classification (CPC):
**H05K 9/0098**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **19.12.2023 US 202363611814 P**

(71) Applicant: **Delta Electronics, Inc.**
**Neihu, Taipei 11491 (TW)**

(72) Inventors:
• **Zhang, Boyi**
  **Durham, NC 27709 (US)**
• **Wang, Ruxi**
  **Durham, NC 27709 (US)**
• **Barbosa, Peter Mantovanelli**
  **Durham, NC 27709 (US)**

(74) Representative: **Uexküll & Stolberg**
**Partnerschaft von**
**Patent- und Rechtsanwälten mbB**
**Beselerstraße 4**
**22607 Hamburg (DE)**

(54) **POWER ELECTRONIC SYSTEM WITH CONDUCTOR HAVING DAMPING FUNCTION**

(57) A power electronic system with conductor (1a) having damping function is provided. The power electronic system includes power components and a conductor (1a). The conductor (1a) is configured to connect the power components, and includes a damping part (11a) disposed on a surface of the conductor (1a). The damping part (11a) is at least partially formed with a damping material having different resistances at different frequencies, and a relative permeability of the damping material is greater than 1 at a frequency higher than 1MHz. The damping part forms first and second paths for first and second power currents flowing between the power components respectively, the first power current is at a frequency higher than 1MHz, the second power current is at a frequency lower than 1MHz, and a resistance of the first path is higher than a resistance of the second path.

FIG. 2

**Description**

FIELD OF THE INVENTION

The present disclosure relates to a power electronic system, and more particularly to a power electronic system with conductors having damping function.

BACKGROUND OF THE INVENTION

Power electronic systems with high capacity and power density are increasingly demanded in transportation electrification and smart grid applications. With the recent development of SiC devices, power electronic systems are able to achieve high efficiency and high power density. However, the fast switching speed combined with the parasitic parameters of the package and PCB (printed circuit board) layout inevitably generate high EMI (electromagnetic interference) noises. The high-frequency noises could lead to device and system failure. The EMI noises could also cause the power electronic system to fail EMC (electromagnetic compatibility) regulations.

The bulky EMI filters are usually used for EMI reduction. Before adding the EMI filters, approaches are needed to reduce or dampen the EMI noise on the board/package level to make sure that the noise would not affect the normal operation of the system.

Therefore, there is a need of providing a power electronic system with a conductor having damping function in order to overcome the drawbacks of the conventional technologies.

SUMMARY OF THE INVENTION

The present disclosure provides a power electronic system with a conductor having damping function. In the power electronic system of the present disclosure, the high-frequency would flow through a high-resistance path and decrease due to the power loss.

In accordance with an aspect of the present disclosure, a power electronic system is provided. The power electronic system includes power components and a conductor. The conductor is configured to connect the power components, and includes a damping part disposed on a surface of the conductor. The damping part is at least partially formed with a damping material having different resistances at different frequencies, and a relative permeability of the damping material is greater than 1 at a frequency higher than 1MHz. The damping part forms first and second paths for first and second power currents flowing between the power components respectively, the first power current is at a frequency higher than 1MHz, the second power current is at a frequency lower than 1MHz, and a resistance of the first path is higher than a resistance of the second path.

In accordance with another aspect of the present disclosure, a power electronic system is provided. The power electronic system includes power components and a conductor. The conductor is configured to connect the power components, and includes a damping part on a surface of the conductor. The damping part has an average roughness greater than $20\mu$m and/or a maximum height roughness greater than $50\mu$m.

The above contents of the present disclosure will become more readily apparent to those ordinarily skilled in the art after reviewing the following detailed description and accompanying drawings, in which:

BRIEF DESCRIPTION OF THE DRAWINGS

FIG. 1A schematically shows the current distribution in a conductor at low frequencies;
FIG. 1B schematically shows the current distribution in the conductor at high frequencies;
FIG. 2 is a schematic cross-sectional view illustrating a conductor according to a first embodiment of the present disclosure;
FIG. 3 is a schematic cross-sectional view illustrating a conductor according to a second embodiment of the present disclosure;
FIG. 4 is a schematic cross-sectional view illustrating a conductor according to a third embodiment of the present disclosure;
FIG. 5 is a schematic cross-sectional view illustrating a conductor according to a fourth embodiment of the present disclosure;
FIG. 6 is a schematic cross-sectional view illustrating a conductor according to a fifth embodiment of the present disclosure;
FIG. 7A is a schematic cross-sectional view illustrating a conductor according to a sixth embodiment of the present disclosure;

FIG. 7B schematically shows the current distribution in different portions of the conductor of FIG. 7A under different frequencies;

FIG. 8A, FIG. 8B and FIG. 8C are schematic perspective views illustrating conductors with different appearances on the surface;

FIG. 9 schematically shows the curves of the resistances of the conductors of FIGS. 8A, 8B and 8C versus the frequency;

FIG. 10 schematically shows a circuit topology employing the conductor proposed in the present disclosure;

FIG. 11 schematically shows a device package employing the conductor proposed in the present disclosure; and

FIG. 12 schematically shows a power module package employing the conductor proposed in the present disclosure.

DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

In the present disclosure, a damping technique is proposed to reduce the high-frequency EMI noise in power electronic systems. The damping technique could help reducing the high-frequency EMI noise caused by the power devices during switching, power electronic systems operation, and device paralleling. The proposed damping technique is an easy-to-implement low-cost technique that leverages the natural behavior of conductors to damp the high-frequency noise in power electronic systems. The proposed damping technique and power electronic system could achieve high efficiency, high power density and good reliability.

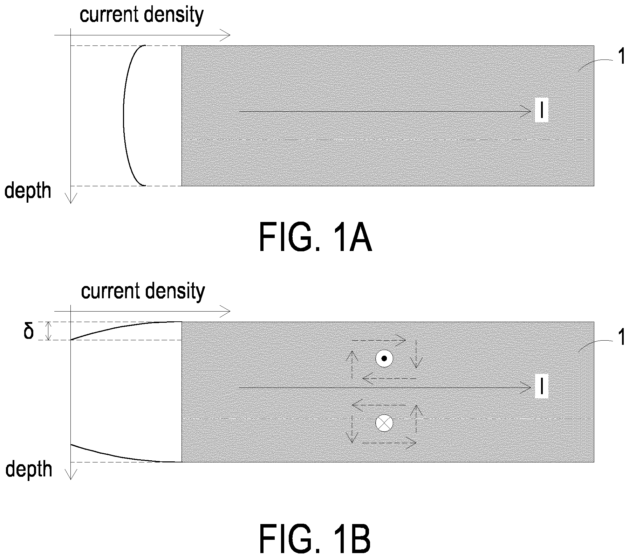

Please refer to FIG. 1A and FIG. 1B. FIG. 1A schematically shows the current distribution in a conductor at low frequencies, and FIG. 1B schematically shows the current distribution in the conductor at high frequencies. In FIG. 1A and FIG. 1B, a current I flows through a conductor 1, and the current distribution is shown by the relations between the current density and the depth in the conductor 1. When the current I is at a low frequency, e.g., lower than 1MHz, as shown in FIG. 1A, the current density in different depths of the conductor 1 are close, namely the current I is evenly distributed in the conductor 1. When the current I is at a high frequency, e.g., higher than 1MHz, as shown in FIG. 1B, the current density at the surface of the conductor 1 is high, while the current density in the middle of the conductor 1 is quite low. In other words, due to the skin and proximity effect, the current I naturally crowds to the skin of the conductor 1. Further, the eddy current generated accordingly is also shown in the figure.

Under high frequencies, the skin depth $\delta$ may be obtained according to equation (1).

$$\delta = \sqrt{\frac{2}{\omega \sigma \mu}} \qquad (1)$$

In equation (1), $\omega$ is the angular frequency, $\sigma$ is the conductivity, and $\mu$ is the permeability. The nature of skin and proximity effect means that the high-frequency current can choose a path different from the low-frequency current to flow.

Since the current I naturally crowds to the skin of the conductor 1 under high frequencies, the present disclosure proposes the conductor with damping function at least on the surface of the conductor to increase the high-frequency resistance for damping the high-frequency noise. The proposed conductor is configured to connect the power components of power electronic systems, thereby improving the efficiency, power density and reliability of power electronic systems. For ease of understanding, several implementations of the conductor are exemplified as follows.

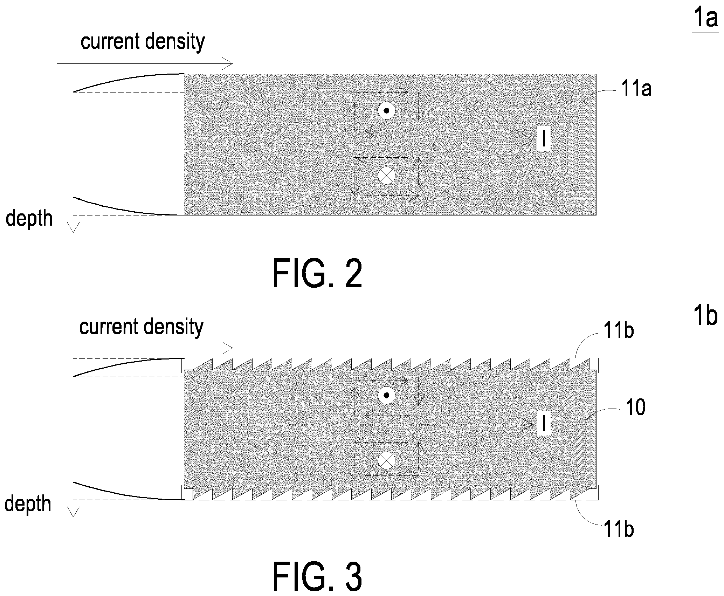

Please refer to FIG. 2. FIG. 2 is a schematic cross-sectional view illustrating a conductor according to a first embodiment of the present disclosure. In FIG. 2, the current distribution of the current I at a high frequency is also shown. As shown in FIG. 2, the conductor 1a includes a damping part 11a formed with a damping material. The damping material has different resistances at different frequencies, and a relative permeability of the damping material is greater than one at a frequency higher than 1MHz. Due to the characteristics of the damping material, the damping part 11a forms first and second paths for first and second power currents flowing between the power components through the conductor 1a respectively. The first power current is at a high frequency (e.g., higher than 1MHz), the second power current is at a low frequency (e.g., lower than 1MHz), and a resistance of the first path is higher than a resistance of the second path. In an embodiment, the damping material has low conductivity and high permeability, such as nickel, iron and aluminum. In an embodiment, the damping material is considered to have permeability higher than copper and conductivity lower than copper.

In addition, the conductor 1a in this embodiment is entirely formed by the damping material, but the present disclosure is not limited thereto. For instance, in another embodiment, the damping material may form only a section of the conductor.

Please refer to FIG. 3. FIG. 3 is a schematic cross-sectional view illustrating a conductor according to a second embodiment of the present disclosure. As shown in FIG. 3, the conductor 1b includes a damping part 11b on a surface of the conductor 1b. The damping part 11b has an average roughness (Ra) greater than $20\mu$m and/or a maximum height roughness (Rz) greater than $50\mu$m. In one embodiment, the damping part 11b has an average roughness (Ra) greater than $20\mu$m. In another embodiment, the damping part 11b has a maximum height roughness (Rz) greater than $50\mu$m. In a further embodiment, the damping part 11b has an average roughness (Ra) greater than $20\mu$m and a maximum height roughness (Rz) greater than $50\mu$m. Accordingly, the damping part 11b forms a rough surface of the conductor 1b, which provide a high resistance. Therefore, when the current I is at a high frequency, the current I naturally crowds to the skin of the conductor 1b and flows through the rough surface with high resistance. Thereby, the high-frequency noise is reduced.

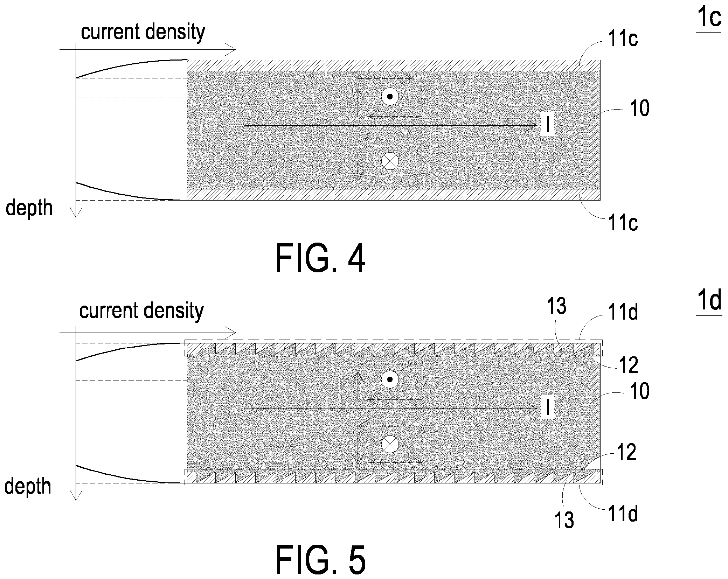

Please refer to FIG. 4. FIG. 4 is a schematic cross-sectional view illustrating a conductor according to a third embodiment of the present disclosure. As shown in FIG. 4, the conductor 1c includes a damping part 11c disposed on a surface of the conductor 1c and formed with the damping material mentioned above. When the current I is at a high frequency, the current I naturally crowds to the skin of the conductor 1b and flows through the damping part 11c with high resistance. Thereby, the high-frequency noise is reduced.

Please refer to FIG. 5. FIG. 5 is a schematic cross-sectional view illustrating a conductor according to a fourth embodiment of the present disclosure. The conductor 1d combines the features of the conductors 1b and 1c. In specific, as shown in FIG. 5, the conductor 1d includes a damping part 11d, and the damping part 11d includes a first layer 12 and a second layer 13. Similarly with the damping part 11b of FIG. 3, the first layer 12 has an average roughness greater than $20\mu$m and/or a maximum height roughness greater than $50\mu$m, and provides a high resistance. In one embodiment, the first layer 12 has an average roughness greater than $20\mu$m and provides a high resistance. In addition, in another embodiment, the first layer 12 has a maximum height roughness greater than $50\mu$m and provides a high resistance. In further another embodiment, the first layer 12 has an average roughness greater than $20\mu$m and a maximum height roughness greater than $50\mu$m and provides a high resistance. The second layer 13 is disposed on the first layer 12 and is formed with the damping material mentioned above. It is noted that the first layer 12 is covered by the second layer 13 in this embodiment, while in another embodiment, the second layer 13 may be configured to fill in indentations of the first layer 12 without completely covering the first layer 12.

It is noted that the shape of the conductor is not limited, and the damping part may be disposed on the partial or entire surface of the conductor. For example, the conductor may be cylindrical (e.g., wiring), rectangle or other suitable shape. Moreover, when the conductor has two opposite surfaces, the conductor may include two damping parts on the two opposite surfaces (e.g., FIG. 3, FIG. 4 and FIG. 5), or may include only one damping part on one surface. Furthermore, if the conductor includes two damping parts, each being at least partially formed with the damping material, on the two opposite surfaces, the damping materials forming the two damping parts may be different but both meet the above definition of the damping material.

In addition, in the embodiments shown in FIG. 3, FIG. 4 and FIG. 5, each of the conductors 1b, 1c and 1d further includes a body part 10, and each of the damping parts 11b, 11c and 11d are disposed on the surface of the body part 10. The body part 10 is for example but not limited to be made of copper, which is widely used in conventional conductors. Taking FIG. 4 as an example, a way of determining the dimensions of conductor 1c is exemplified as follows. The relations between the dimensions of conductor 1c and the thickness, conductivity and resistance of body part 10 are shown in equation (2).

$$t_m = \frac{l_0}{\sigma_m \cdot d \cdot R_m} \qquad (2)$$

In equation (2), $t_m$ is the thickness of the body part 10, $l_0$ is the specific length of the conductor 1c, $\sigma_m$ is the conductivity of the body part 10, d is the effective width of the body part 10, and $R_m$ is the resistance of the body part 10. According to the foregoing descriptions, the body part 10 forms the main path for transmitting the low-frequency current. Therefore, given a desired resistance at low frequency, the thickness $t_m$ of the body part 10 can be calculated through equation (2).

Further, an equation associated with the resistance of the layer formed with the damping material, i.e., the damping part 11c, is shown as:

$$R_s = \frac{\tau_r \cdot l_0}{d} \cdot \sqrt{\frac{\omega \mu_r \mu_i}{2\sigma_s}} \qquad (3)$$

In equation (3), $R_s$ is the resistance of the damping part 11c, $\tau_r$ is the surface roughness coefficient, $\omega$ is the angular frequency, $\mu_r$ is the relative permeability of the damping material, $\mu_i$ is the initial permeability, and $\sigma_s$ is the

conductivity of the damping material. As the angular frequency $\omega$ and the resistance $R_s$ are defined to damp the high-frequency noise, the specific length $l_0$ and effective width d (i.e., the dimensions) of the conductor 1c can be calculated through equation (3). Additionally, based on equation (3), increasing the surface roughness would increase the surface roughness coefficient $\tau_r$, resulting in higher resistance $R_s$. Namely, in the conductor 1d of FIG. 5, the first layer 12 of damping part 11d which forms a rough surface would further increase the resistance of damping part 11d.

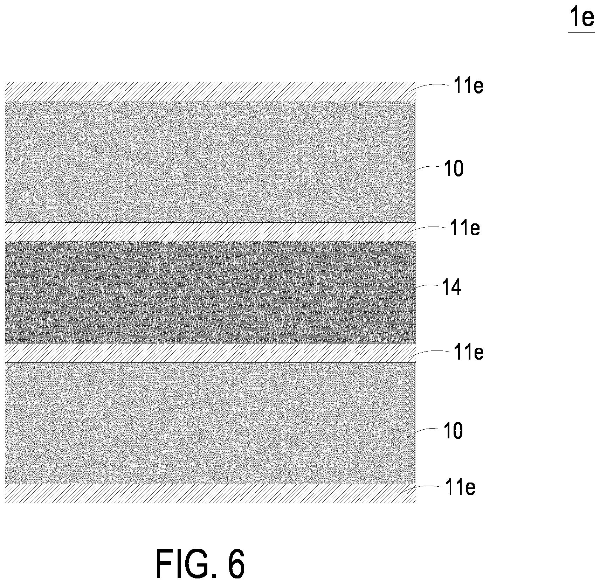

Additionally, in the present disclosure, the conductor may be a multi-layer structure. Please refer to FIG. 6. FIG. 6 is a schematic cross-sectional view illustrating a conductor according to a fifth embodiment of the present disclosure. As shown in FIG. 6, the conductor 1c includes a plurality of body part 10 and a plurality of damping parts 11e, and each damping part 11e is formed with the damping material defined above. Two opposite surfaces of each body part 10 are covered by two damping parts 11e respectively. Further, in the conductor 1c, any two body parts 10 neighboring to each other are insulated by an insulation layer 14 formed with insulation material. It is noted that the specific materials that form the plurality of damping parts 11e respectively may be identical or different, but all meet the definition of the damping material of the present disclosure.

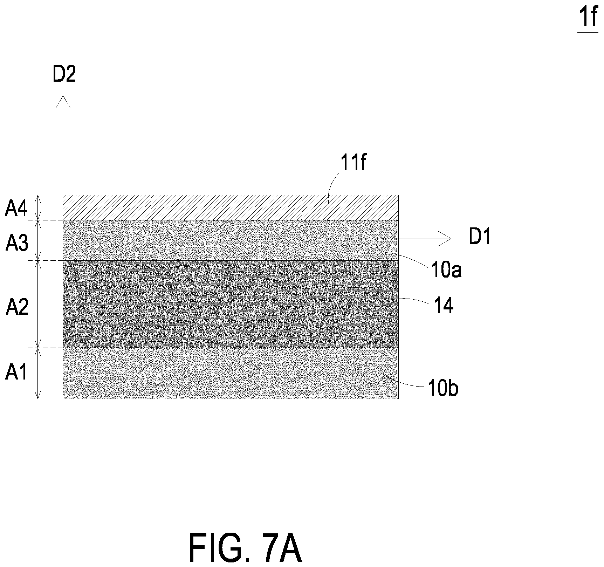

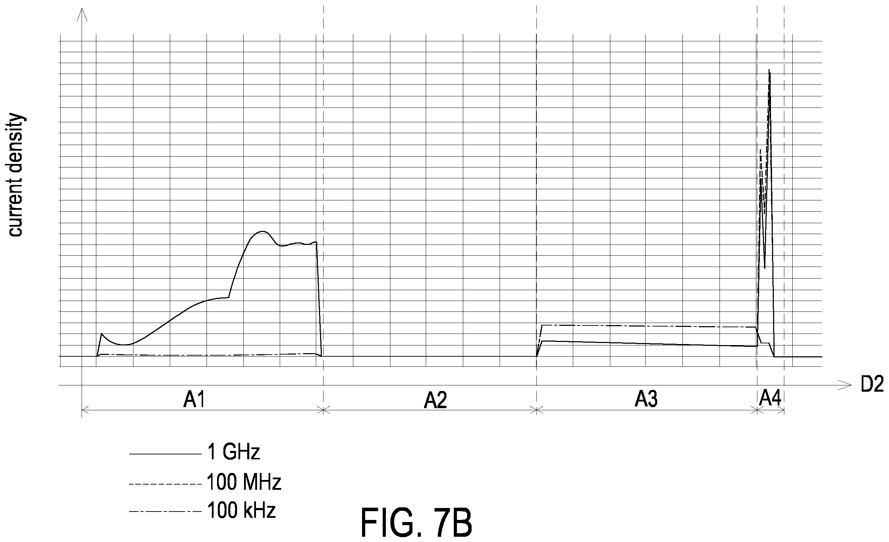

Please refer to FIG. 7A and FIG. 7B. FIG. 7A is a schematic cross-sectional view illustrating a conductor according to a sixth embodiment of the present disclosure. As shown in FIG. 7A, the conductor 1f includes two body parts 10a and 10b, an insulation layer 14 and a damping part 11f. The insulation layer 14 is between the body parts 10a and 10b for insulating the body parts 10a and 10b from each other, and the damping part 11f is disposed on the body part 10a. In FIG. 7A, a current direction D1 and an observation line D2 are shown. Along the observation line D2, A1, A2, A3 and A4 represent the regions of the body part 10b, the insulation layer 14, the body part 10a and the damping part 11f respectively. FIG. 7B schematically shows the current distribution in different portions of the conductor of FIG. 7A under different frequencies. In FIG. 7B, the current distribution under the frequencies of 100kHz, 100MHz and 1GHz are depicted by solid line, dashed line and dot chain line, respectively. As shown in FIG. 7A and FIG. 7B, under 100kHz, the current mainly flows through the body part 10a; under 100MHz, the current mainly flows through the damping part 11f; and under 1GHz, the current mainly flows through the damping part 11f and the body part 10b.

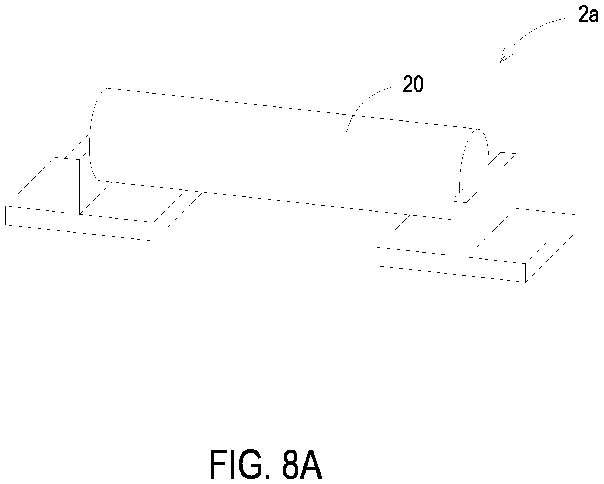

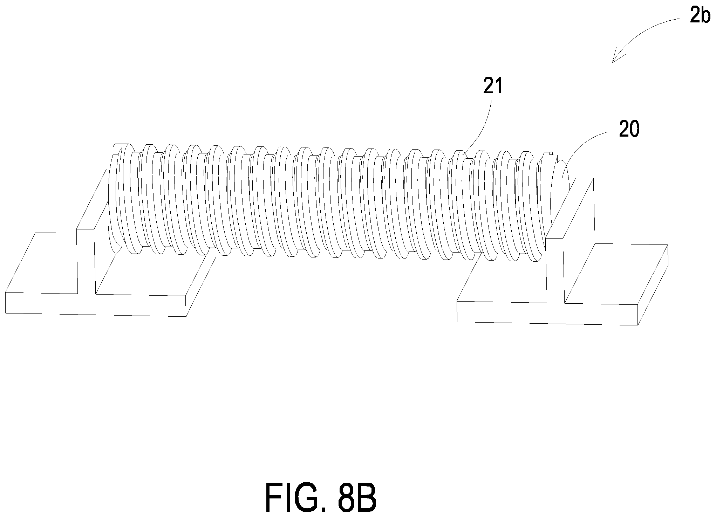

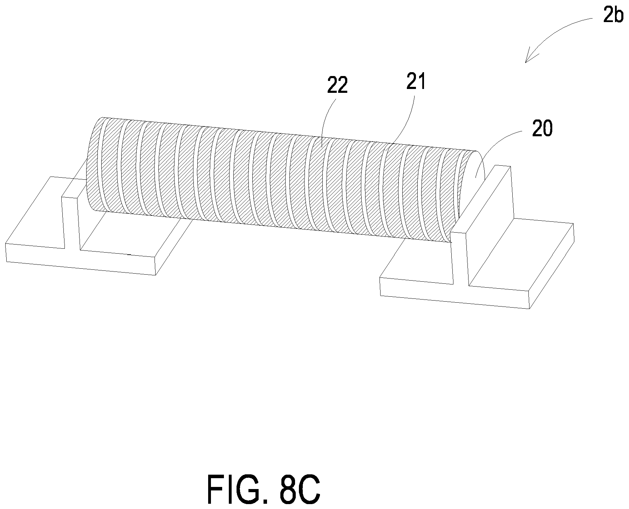

FIG. 8A, FIG. 8B and FIG. 8C are schematic perspective views illustrating conductors with different appearances on the surface. In FIG. 8A, the conductor 2a includes a body part 20 with a smooth surface. In FIG. 8B, the conductor 2b includes a body part 20 and a rough layer 21 (thread). The rough layer 21 is disposed on the body part 20 and has an average roughness greater than $20\mu$m and/or a maximum height roughness greater than $50\mu$m. In one embodiment, the rough layer 21 is disposed on the body part 20 and has an average roughness greater than $20\mu$m. In another embodiment, the rough layer 21 is disposed on the body part 20 and has a maximum height roughness greater than $50\mu$m. In further another embodiment, the rough layer 21 is disposed on the body part 20 and has an average roughness greater than $20\mu$m and a maximum height roughness greater than $50\mu$m. In FIG. 8C, the conductor 2c includes a body part 20, a rough layer 21 and a damping material 22. The rough layer 21 is similar with that shown in FIG. 8B. The damping material 22 meets the definition of the above-mentioned damping material and is filled in indentations of the rough layer 21.

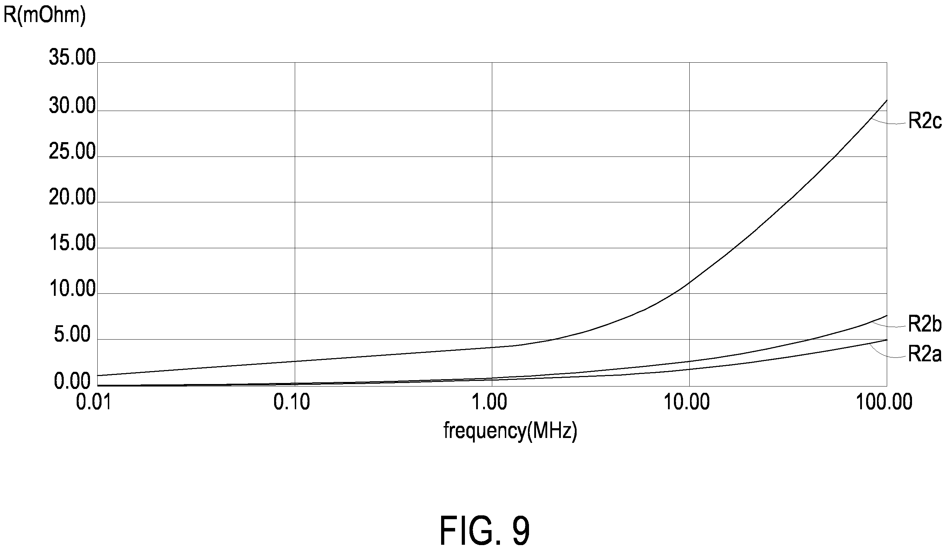

FIG. 9 schematically shows the curves of the resistances of the conductors of FIGS. 8A, 8B and 8C versus the frequency. In FIG. 9, R2a, R2b and R2c represents the resistances of the conductors 2a, 2b and 2c of FIGS. 8A, 8B and 8C respectively. As shown in FIG. 9, when the frequency is lower than 1MHz, the resistances R2a and R2b are nearly the same, and the resistance R2c is greater than the resistances R2a and R2b. When the frequency is higher than 1MHz, the resistance R2b gradually increases to be larger than the resistance R2a. When the frequency is 100MHz, the resistance R2c is much greater than the resistances R2a and R2b. It can be seen that the damping material can greatly increase the resistance under high frequency, and thus the high-frequency noise can be effectively reduced.

In the present disclose, the proposed conductor is configured to connect the power components of the power electronic system. It is noted that the specific implementations of the power electronic system and the power components thereof are not limited. In other words, the conductor may be used in various kinds of power electronic system for damping the high-frequency noise. For instance, the proposed conductor may be configured as a trace of a printed circuit board, a terminal pin of a device package, or a trace, a clip or a lead frame terminal of a power module package, but not exclusively. Some examples are exemplified as follows.

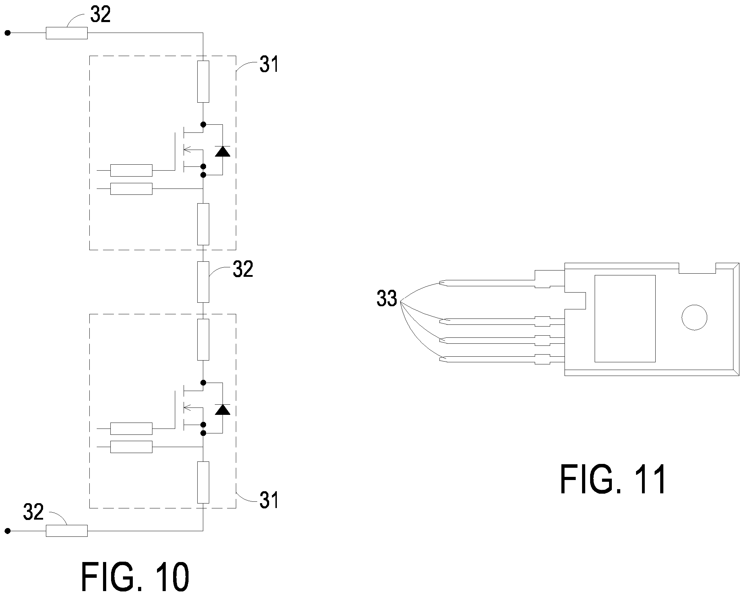

FIG. 10 schematically shows a circuit topology employing the conductor proposed in the present disclosure. As shown in FIG. 10, the switch components 31 are connected through the conductors 32, and the conductors 32 may be implemented by the conductor proposed in the present disclosure to damp the high-frequency noise. For instance, the switch components 31 may be the power components on a printed circuit board, and the conductors 32 may be the traces of the printed circuit board.

FIG. 11 schematically shows a device package employing the conductor proposed in the present disclosure. As shown in FIG. 11, the pins 33 of the device package may adopt the conductor proposed in the present disclosure the damp the high-frequency noise.

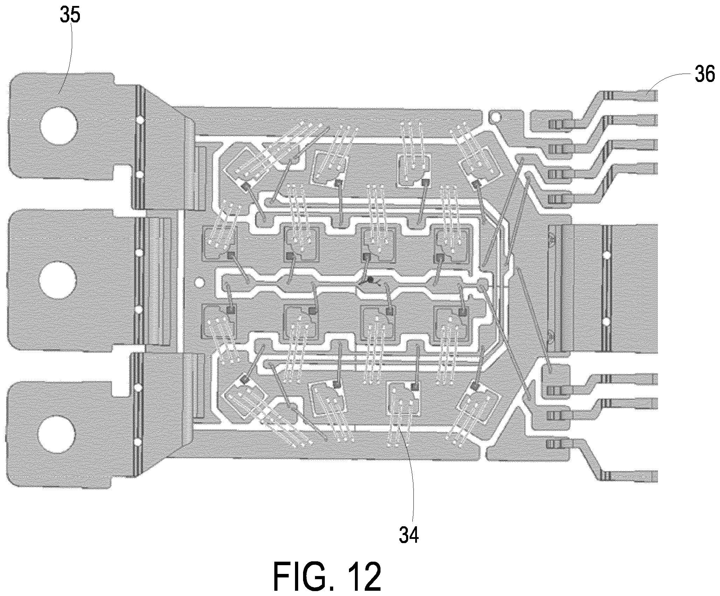

FIG. 12 schematically shows a power module package employing the conductor proposed in the present disclosure. As shown in FIG. 12, the wire bonds 34 and the lead frame terminals 35 and 36 may adopt the conductor proposed in the present disclosure to damp the high-frequency noise. In addition, in the power module package of FIG. 12, the traces on the substrate and the clops may also adopt the conductor proposed in the present disclosure.

**Claims**

1. A power electronic system, **characterized by** comprising:

   power components; and
   a conductor (1), configured to connect the power components, and comprising a damping part (11a) disposed on a surface of the conductor (1), wherein the damping part (11a) is at least partially formed with a damping material having different resistances at different frequencies, and a relative permeability of the damping material is greater than 1 at a frequency higher than 1MHz,
   wherein the damping part (11a) forms first and second paths for first and second power currents flowing between the power components respectively, the first power current is at a frequency higher than 1MHz, the second power current is at a frequency lower than 1MHz, and a resistance of the first path is higher than a resistance of the second path.

2. The power electronic system according to claim 1, wherein the damping part (11d) comprises a first layer (12) and a second layer (13), the first layer (12) has an average roughness greater than $20\mu$m and/or a maximum height roughness greater than $50\mu$m, and the second layer (13) is disposed on the first layer (12) and is formed by the damping material.

3. The power electronic system according to claim 2, wherein the first layer (12) is covered by the second layer (13).

4. The power electronic system according to claim 2, wherein the second layer (22) is configured to fill in indentations of the first layer (21).

5. The power electronic system according to claim 2, wherein the conductor (1d) comprises two said damping parts (11d) on two opposite surfaces of the conductor (1d).

6. The power electronic system according to claim 5, wherein two second layers (13) of the two damping parts (11d) are formed by a first material and a second material, which are different and are both comprised by the damping material, respectively.

7. The power electronic system according to claim 1, wherein the conductor (1c) comprises two said damping parts (11c) on two opposite surfaces of the conductor (1c).

8. The power electronic system according to claim 7, wherein the two damping parts (11c) are formed by a first material and a second material, which are different and are both comprised by the damping material, respectively.

9. The power electronic system according to claim 1, wherein the conductor (1e) comprises a plurality of body parts (10), two opposite surfaces of each of the plurality of body parts (10) are covered by two said damping parts (11e) respectively, and any two of the plurality of body parts (10) neighboring to each other are insulated by an insulation layer (14).

10. The power electronic system according to claim 1, wherein the damping material comprises nickel, iron and aluminum.

11. The power electronic system according to claim 1, wherein the conductor (1a) is configured as a trace of a printed circuit board, a terminal pin (33) of a device package, or a trace, a clip or a lead frame terminal (35, 36) of a power module package.

12. A power electronic system, **characterized by** comprising:

   power components; and
   a conductor (1b), configured to connect the power components, and comprising a damping part (11b) on a surface of the conductor (1b), wherein the damping part (11b) has an average roughness greater than $20\mu$m and/or a maximum height roughness greater than $50\mu$m.

13. The power electronic system according to claim 12, wherein the conductor (1b) comprises two said damping parts (11b) on two opposite surfaces of the conductor (1b).

current density

depth

1

I

## FIG. 1A

current density

$\delta$

depth

1

I

## FIG. 1B

EP 4 576 970 A1

current density

depth

FIG. 2

current density

depth

FIG. 3

EP 4 576 970 A1

FIG. 4

FIG. 5

EP 4 576 970 A1

FIG. 6

FIG. 7A

EP 4 576 970 A1

FIG. 7B

current density

1 GHz
100 MHz
100 kHz

A1    A2    A3    A4

D2

EP 4 576 970 A1

2a

20

FIG. 8A

FIG. 8B

FIG. 8C

EP 4 576 970 A1

FIG. 9

EP 4 576 970 A1

FIG. 11

33

FIG. 10

31

32

31

32

32

FIG. 12

# EP 4 576 970 A1

Europäisches
Patentamt

European
Patent Office

Office européen
des brevets

## EUROPEAN SEARCH REPORT

Application Number

EP 24 22 1114

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/393161 A1 (ZHONG SHENG [US] ET AL) 26 December 2019 (2019-12-26) * paragraph [0017] - paragraph [0029]; figures 1-5 * | 1-13 | INV. H05K9/00 |
| A | US 2012/032330 A1 (MUTNURY BHYRAV M [US] ET AL) 9 February 2012 (2012-02-09) * paragraph [0020] - paragraph [0034]; figures 3-5 * | 1-13 | |
| A | TIMSIT R S: "HIGH SPEED LELECTRONIC CONNECTORS: A REVIEW OF ELECTRICAL CONTACT PROPERTIES", IEICE TRANSACTIONS ON ELECTRONICS, INSTITUTE OF ELECTRONICS, TOKYO, JP, vol. E88-C, no. 8, 1 August 2005 (2005-08-01), pages 1532-1545, XP001232830, ISSN: 0916-8524, DOI: 10.1093/IETELE/E88-C.8.1532 * page 2 - page 7 * | 1-13 | |
| A | TIMSIT R S: "High Speed Electronic Connector Design: A Review of Electrical and Electromagnetic Properties of Passive Contact Elements - Part 1", IEICE TRANSACTIONS ON ELECTRONICS, INSTITUTE OF ELECTRONICS, TOKYO, JP, vol. E91C, no. 8, 1 August 2008 (2008-08-01), pages 1178-1191, XP001515942, ISSN: 0916-8524, DOI: 10.1093/IETELE/E91-C.8.1178 * the whole document * | 1-13 | TECHNICAL FIELDS SEARCHED (IPC) H05K |

The present search report has been drawn up for all claims

| Place of search | Date of completion of the search | Examiner |
|---|---|---|
| The Hague | 9 May 2025 | Martinez Izquierdo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 22 1114

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2025

| Patent document cited in search report | Publication date | Patent family member(s) | Publication date |
|---|---|---|---|
| US 2019393161 A1 | 26-12-2019 | NONE | |
| US 2012032330 A1 | 09-02-2012 | US 2010099219 A1 | 22-04-2010 |
| | | US 2012032330 A1 | 09-02-2012 |

EPO FORM P0459

For more details about this annex : see Official Journal of the European Patent Office, No. 12/82